# EUROPÄISCHE PATENTSCHRIFT

(11) **EP 1 404 891 B1**
(45) Veröffentlichungstag und Bekanntmachung des Hinweises auf die Patenterteilung: **11.10.2006**
(21) Anmeldenummer: 02782434.1
(22) Anmeldetag: 22.04.2002
(51) Int. Cl.: C23C 16/458, C23C 16/46, C30B 25/12, C30B 25/10

(54) **CVD-VORRICHTUNG MIT DIFFERENZIERT TEMPERIERTEM SUBSTRATHALTER**
CVD SYSTEM COMPRISING A THERMALLY DIFFERENTIATED SUBSTRATE SUPPORT
DISPOSITIF CVD POURVU D'UN PORTE-SUBSTRAT A TEMPERATURE DIFFERENCIEE

(30) Priorität: 04.07.2001 DE 10132448
(43) Veröffentlichungstag der Anmeldung: 07.04.2004
(73) Patentinhaber: Aixtron AG, 52072 Aachen (DE)
(72) Erfinder: KÄPPELER, Johannes, 52146 Würselen (DE)
(74) Vertreter: Grundmann, Dirk
(86) Internationale Anmeldenummer: PCT/EP2002/004405
(87) Internationale Veröffentlichungsnummer: WO 2003/004724

(56) Entgegenhaltungen:
- EP-A- 0 519 608
- DE-A- 19 940 033
- DE-C- 19 622 402
- US-A- 5 226 383
- US-A- 5 788 777
- US-A- 6 001 183

## Beschreibung

Die Erfindung betrifft eine Vorrichtung zum Abscheiden insbesondere kristalliner Schichten auf ein insbesondere kristallines Substrat, mit einem hochfrequenzbeheizten Substrathalter aus leitfähigem Material zur flächenaufliegenden Halterung des Substrates, welcher Substrathalter Zonen höherer elektrischer Leitfähigkeit aufweist.

Eine derartige CVD-Vorrichtung beschreibt die DE 199 40 033. Diese Schrift beschreibt eine Vorrichtung zum Abscheiden insbesondere Siliciumcarbid-Schichten in einem Reaktor, dessen Wände einen allseitig beheizten Strömungskanal ausbilden. Im Strömungskanal und insbesondere im Bereich des Substrathalter sollen dort dünne Platten aus inerten Materialien, beispielsweise Tantal, Molybdän oder Wolfram eingelegt werden, um die Hochfrequenzeinkopplung und damit den Energieeintrag lokal zu beeinflussen.

Bei Vorrichtungen, die zum Abscheiden kristalliner Schichten auf insbesondere kristallinen Substraten dienen, bei denen nur der Substrathalter geheizt wird, die restlichen Reaktorwände aber nicht aktiv beheizt werden, treten an der Oberfläche des Substrathalters erhebliche Strahlungsverluste auf. Die Größe der Strahlungsverluste hängt in entscheidendem Maße von der Qualität der Oberfläche des Substrathalters ab. Der Substrathalter ist in der Regel nur teilweise mit Substraten belegt. Zwischen dem Substrat und der Oberfläche des Substrathalters entstehen zufolge fertigungsbedingter Ungenauigkeiten bzw. Wärmeverzug Spalten, die isolierend wirken. Die Erfindung betrifft auch solche Vorrichtungen, bei denen die Substrate auf gesonderten Substratlagerscheiben liegen, die in Aussparungen des Substrathalters einliegen. Die Substratlagerscheiben liegen bei diesen Vorrichtungen auf einem Gaslager, welches sich dreht, so dass die Substrathalterlagerscheiben drehangetrieben werden. Dieser Gasspalt, der zwischen Substratlagerscheibe und dem Boden der Aussparung liegt, bildet eine Isolierschicht. Auch dies hat zur Folge, dass die Substrattemperatur geringer ist, als die Oberflächentemperatur des Substrathalters in der unmittelbaren Nachbarschaft des Substrates.

Diese Temperaturdifferenz hat einen negativen Einfluss auf das Schicht-Wachstumsverhalten.

Der Erfindung liegt daher die Aufgabe zugrunde, Maßnahmen anzugeben, um das Temperaturprofil im Bereich des Substrathalters oder in der unmittelbar darüber liegenden Gasschicht zu vergleichmäßigen.

Gelöst wird die Aufgabe zunächst und im Wesentlichen vom Gegenstand des Anspruches 1, in welchem darauf abgestellt ist, dass die höher leitfähige Zone der Auflagefläche des Substrates zugeordnet ist. Die in den weiteren Ansprüchen angegebenen Gegenstände betreffen sowohl vorteilhafte Weiterbildungen zum Gegenstand des Anspruches 1 als auch gleichzeitig davon und von der oben genannten Aufgabenstellung unabhängige, eigenständige technische Lösungsvorschläge. Es wird dort vorgeschlagen, dass die Zone höherer Leitfähigkeit im Wesentlichen der vom Substrat eingenommenen Fläche entspricht. Ferner ist dort vorgesehen, dass die Zone durch ein Einsatzstück aus Metall gebildet ist. Es ist von Vorteil, wenn jedes einer Vielzahl von auf dem Substrathalter aufliegenden Substrate über einer Zone mit höherer elektrischer Leitfähigkeit liegt, welche Zone die identischen Flächenmaße besitzt wie das Substrat. Dann ist sichergestellt, dass das Substrat auf einer Zone des Substrathalters liegt, die heißer ist als die das Substrat umgebende Substrathalteroberfläche. Mit dieser Ausgestaltung können Wärmetransportverluste kompensiert werden. Mit dieser Ausgestaltung ist darüber hinaus aber auch der Vorteil verbunden, dass man durch geeignete Überdimensionierung der höher elektrisch leitfähigen Zonen eine Temperaturprofil erzeugen kann, bei dem die Zonen des Substrathalters, auf welchen die Substrate liegen, heißer sind, als die die Substrate umgebende Oberfläche des Substrathalters. Insbesondere wird es als vorteilhaft angesehen, dass der Substrathalter ein oder mehrere insbesondere gasdrehgelagerte Substratlagerscheiben aufweist, denen jeweils ein Einsatzstück zugeordnet ist. Das Einsatzstück bzw. die elektrisch höher leitende Zone kann dabei der Substratlagerscheibe selbst zugeordnet sein. Es ist insbesondere von Vorteil, wenn die gesamte Substratlagerscheibe aus Metall besteht. Es ist aber auch vorgesehen, um insbesondere die Masse der Substratlagerscheibe zu minimieren, dass die Substratlagerscheibe in einer Lagerausnehmung des Substrathalters auf einem Gaslager liegt und das Einsatzstück bzw. die elektrisch höher leitende Zone dem Boden der Lagerausnehmung zugeordnet ist. Als Material für das Einsatzstück eignet sich Molybdän, Tantal oder Wolfram. Ein inertes Material ist vorzuziehen. Der Substrathalter kann von einer Hochfrequenz-Spule umgeben sein. Es kann sich um einen Tunnelreaktor handeln. In einer Alternative dazu kann der Substrathalter aber auch als Kreiszylinderscheibe ausgestaltet sein, welche oberhalb einer als Planarspule ausgebildeten Hochfrequenz-Spule angeordnet ist. Die Substrathalter-Scheibe kann sich bei dieser Art des "Planetenreaktors" selbst drehen. Die einzelnen, mit Planeten bezeichneten Substratlagerscheiben drehen sich wiederum um ihre eigene Achse. Um durch die Substrathalterrotation auftretende Fliegkräfte, die auf die Substratlagerscheiben wirken, aufzufangen, können die Lagerausnehmungen zentrale Lagerstifte ausbilden, die in zugeordnete Lagerausnehmungen der Substratlagerscheiben eingreifen.

Ausführungsbeispiele der Erfindung werden nachfolgend anhand beigefügter Zeichnungen erläutert. Es zeigen:
- Fig.1: in der Draufsicht einen drehangetriebenen, kreisscheibenförmigen Substrathalter mit planetenartig angeordneten Substratlagerscheiben, welche auf einem Gaslager aufliegend um ihre eigene Achse rotieren,
- Fig. 2: einen Schnitt gemäß der Linie II-II in Fig.1,
- Fig. 3: eine Teildarstellung gemäß Fig. 2 einer Variante,
- Fig. 4: eine Darstellung gemäß Fig. 3 einer weiteren Variante,
- Fig. 5: eine aufgeschnittene perspektivische Darstellung eines Tunnelreaktors und
- Fig. 6: einen Schnitt gemäß der Linie VI-VI in Fig. 5.

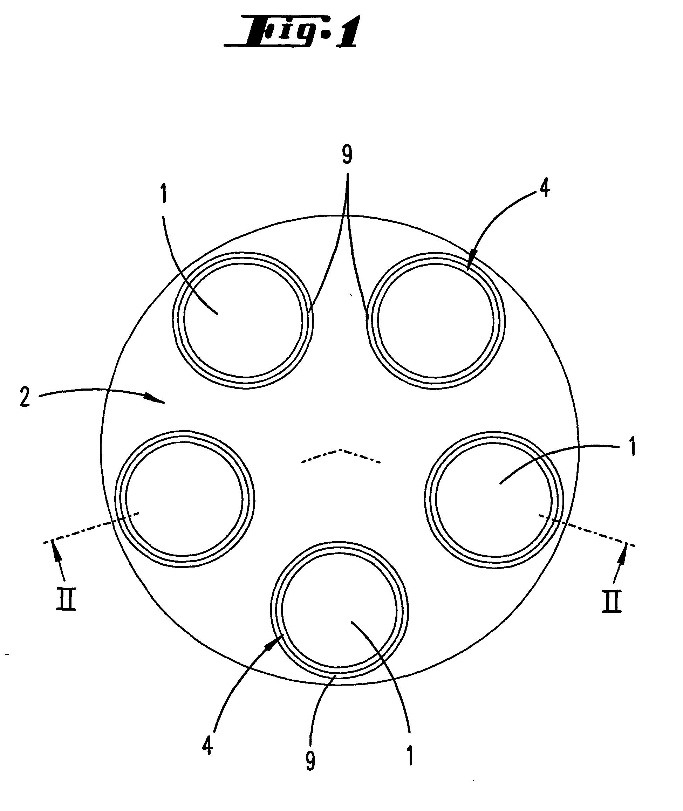

Der in den Figuren 1 - 4 dargestellte Substrathalter 2 besteht aus einem kreisscheibenzylinderförmigen Grafitblock, der um seine eigene Achse drehangetrieben in einem Reaktor liegt. Die reaktiven Gase werden durch eine oberhalb und in der Mitte des Substrathalters angeordnete Zuleitung in die Prozesskammer gebracht. Die Wände dieser Prozesskammer sind nicht beheizt. Sie wärmen sich lediglich durch die Strahlung des von unten mittels einer HF-Spule 5 geheizten Substrathalters 2 auf. Dies hat zur Folge, dass innerhalb der Prozesskammer vom Substrathalter 2 hin zu den nicht dargestellten Prozesskammerwänden ein Temperaturgefälle besteht. Die in die Prozesskammer eingebrachten reaktiven Gase, bei den es sich um Trimethyl-Gallium, Trimethyl-Indium, Arsin und/ oder Phosphin handeln kann, zerlegen sich teilweise in der Gasphase und auf der Substratoberfläche. Die Zerlegungsprodukte bilden auf der Substratoberfläche eine Halbleiterschicht aus III-V-Material. Da die Zerlegungsreaktion, zumindest der III-er Ausgangsstoffe, im Wesentlichen ausschließlich auf der Substratoberfläche stattfinden sollen und nicht auf dem benachbarten Substrathalter, ist es erforderlich, dass die Temperatur der Substratoberfläche höher ist als die Temperatur der Oberfläche der dem Substrat benachbarten Substrathalterfläche. Die Erfindung betrifft demzufolge eine Weiterbildung eines bekannten MOCVD-Reaktors.

Um die Temperatur des Substrates 1 zumindest auf die Temperatur zu bringen, wie die Temperatur der das Substrat umgebenden Oberfläche des Substrathalters 2 ist vorgesehen, dass unterhalb des Substrates 1 innerhalb des Substralters 2 Einsatzstücke 3 aus Metall einliegen. Als Metall kommt Wolfram, Tantal oder bevorzugt Molybdän in Betracht. Diese Metalleinlage, die sich im Wesentlichen flächendeckend unterhalb des Substrates 1 erstreckt, hat zur Folge, dass die von der HF-Spule 5 ausgesandte Hochfrequenz stärker ankoppelt. Dies hat eine erhöhte Wärmeumsetzung im Einsatzstück 3 zur Folge. Dadurch heizt sich das Substrat 1, was nahezu unmittelbar oberhalb des Einsatzstückes 3 liegt, stärker auf, als der das Substrat 1 umgebende Substrathalter.

Bei dem in Figur 2 dargestellten Ausführungsbeispiel liegt das Substrat 1 nahezu flächenfüllend auf einer Substratlagerscheibe 4 auf. Die Substratlagerscheibe 4 besteht ebenfalls aus Grafit. Sie hat jedoch auf ihrer Unterseite, die gegenüberliegend zum Boden der Lagerausnehmung 9 angeordnet ist, ein Einsatzstück 3 aus Molybdän. Die Größe des Einsatzstückes 3 entspricht bis auf einen schmalen Randstreifen der kreisscheibenförmigen Substratlagerscheibe 4. Zur zentrierenden Lagerung der Substratlagerscheibe 4 besitzt das Einsatzstück 3 in seiner Mitte eine Lageröffnung 8. In die Lageröffnung 8 greift ein im Zentrum des Bodens der Lagerausnehmung 9 entspringender Lagerstift 7 ein, um die auf einem Gaslager drehende Substratlagerscheibe 4 zentriert zu halten, wenn sich der gesamte Substrathalter 2 um seine eigene Achse dreht. Der Drehantrieb der Substratlagerscheibe 4 erfolgt in bekannter Weise mittels eines Gasflusses, der durch nicht dargestellte Kanäle des Substrathalters 2 strömt. Diese Kanäle münden in spiralförmigen Nuten im Boden der Lagerausnehmung 9 und bringen die Substratlagerscheibe 4 durch viskose Kräfte zum Drehen.

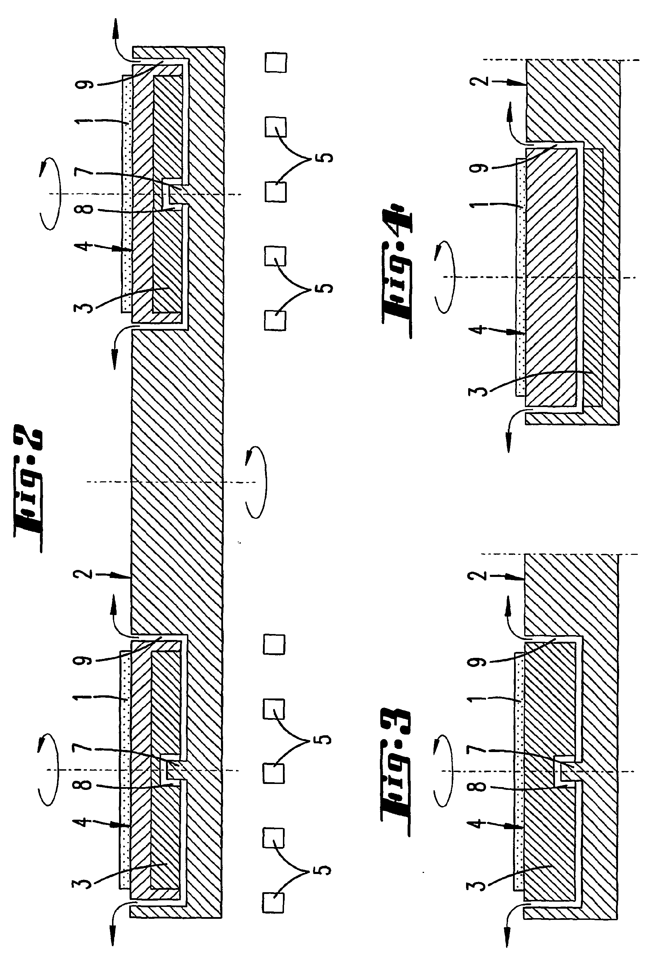

Bei dem in Fig. 3 dargestellten Ausführungsbeispiel ist die gesamte Substratlagerscheibe 4 als Metallblock ausgestaltet.

Bei dem in Fig. 4. Dargestellten Ausführungsbeispiel ist die Substratlagerscheibe 4 insgesamt aus Grafit. Bei dieser Ausgestaltung kann auf den Lagerstift 7 verzichtet werden, da die Masse der Substratlagerscheibe 4 geringer ist als diejenige im Ausführungsbeispiel der Fig. 3. Beim Ausführungsbeispiel der Fig. 4 liegt etwa flächenidentisch unterhalb der Substratlagerscheibe 4 im Substrathalter 2 ein Einsatzstück 3 aus Molybdän. Die nach oben freie Oberfläche des Einsatzstückes 3 bildet den Boden der Lagerausnehmung 9. Die Kanäle, durch welche das Gas zur Aufrechterhaltung des drehtreibenden Gaslagers fließt, können durch den Molybdänblock 3 strömen.

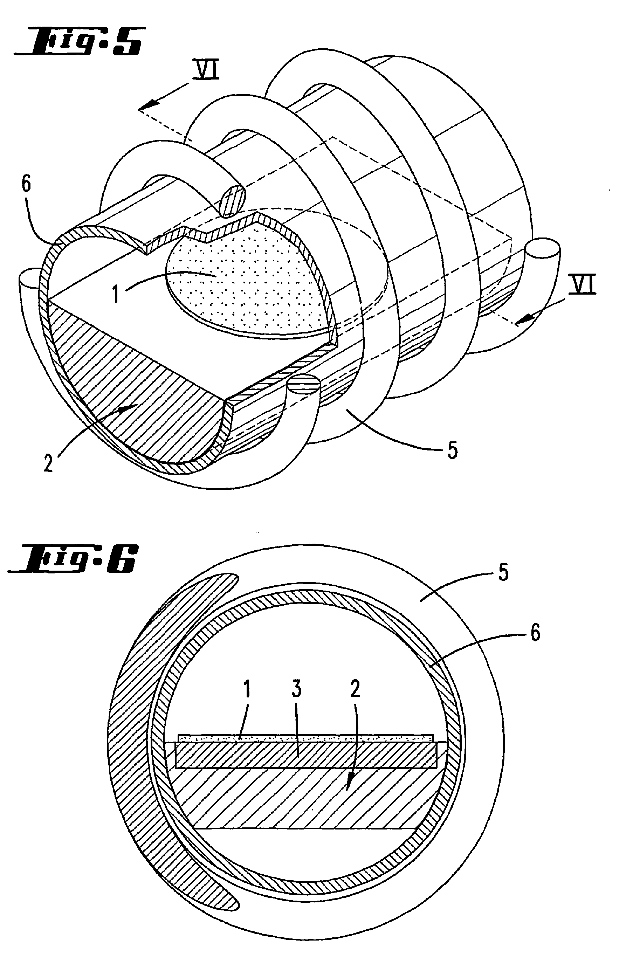

Das in den Figuren 5 und 6 dargestellte Ausführungsbeispiel betrifft einen Tunnelreaktor. Dieser besteht aus einem Quarzrohr 6, um welches eine HF-Spule 5 gewunden ist. Innerhalb des Quarzrohres 6, im Bereich der HF-Spule 5 befindet sich ein Substrathalter 2 aus Grafit. Auf der ebenen Oberfläche des Substrathalters 2 liegt das Substrat 1 auf.

Wie aus der Fig. 6 entnehmbar ist, liegt nahezu exakt unterhalb des Substrates 1 ein Einsatzstück 3 in einer Aussparung des Substrathalters 2 formschlüssig ein. Das Substrat 1 liegt bei diesem Ausführungsbeispiel unmittelbar auf der Oberfläche des Einsatzstückes 3 auf. Die Oberfläche des Einsatzstückes 3, welches aus Molybdän bestehen kann, kann in geeigneter Weise ebenso wie die Oberfläche des das Einsatzstück 3 umgebenden Substrathalters beschichtet sein.

Mit den Ausgestaltungen, die zuvor beschrieben worden sind und die in den Zeichnungen dargestellt sind, lässt sich eine Überhöhung der Substrattemperatur gegenüber der das Substrat umgebenden Oberfläche des Substrathalters 2 erreichen. Dies kann sogar parasitäres Wachstum außerhalb der Substratoberfläche reduzieren.

Alle offenbarten Merkmale sind (für sich) erfindungswesentlich. In die Offenbarung der Anmeldung wird hiermit auch der Offenbarungsinhalt der zugehörigen/beigefügten Prioritätsunterlagen (Abschrift der Voranmeldung) vollinhaltlich mit einbezogen, auch zu dem Zweck, Merkmale diese Unterlagen in Ansprüche vorliegender Anmeldung mit aufzunehmen.

## Patentansprüche

1. Vorrichtung zum Abscheiden insbesondere kristalliner Schichten auf einem insbesondere kristallinen Substrat (1) mit einem hochfrequenzbeheizten Substrathalter (2) aus leitfähigem Material zur flächenaufliegenden Halterung des Substrates (1), welcher Substrathalter (2) eine Zone (3) höherer elektrischer Leitfähigkeit aufweist, **dadurch gekennzeichnet, dass** die höher elektrisch leitfähige Zone der Auflagefläche des Substrates (1) zugeordnet ist.

2. Vorrichtung nach Anspruch 1 oder insbesondere danach, **dadurch gekennzeichnet, dass** die Zone (3) höherer elektrischer Leitfähigkeit im Wesentlichen der vom Substrat (1) eingenommenen Fläche entspricht.

3. Vorrichtung nach einem oder mehreren der vorhergehenden Ansprüche oder insbesondere danach, **dadurch gekennzeichnet, dass** die Zone (3) durch ein Einsatzstück (3) aus Metall gebildet ist in einem aus insbesondere beschichtetem Grafit bestehenden Substrathalter (2).

4. Vorrichtung nach einem oder mehreren der vorhergehenden Ansprüche oder insbesondere danach, **dadurch gekennzeichnet, dass** der Substrathalter (2) ein oder mehrere insbesondere gasdrehgelagerte Substratlagerscheiben (4) aufweist, denen jeweils ein Einsatzstück (3) zugeordnet ist.

5. Vorrichtung nach einem oder mehreren der vorhergehenden Ansprüche oder insbesondere danach, **dadurch gekennzeichnet, dass** das Einsatzstück (3) unmittelbar der Substratlagerscheibe (4) zugeordnet ist und insbesondere die gesamte Substratlagerscheibe (4) aus Metall besteht.

6. Vorrichtung nach einem oder mehreren der vorhergehenden Ansprüche oder insbesondere danach, **gekennzeichnet durch** eine Vielzahl von planetenartig auf einem Substrathalter angeordnete Substratlagerscheiben (4).

7. Vorrichtung nach einem oder mehreren der vorhergehenden Ansprüche oder insbesondere danach, **dadurch gekennzeichnet, dass** die Substratlagerscheibe (4) in einer Lagerausnehmung (9) des Substrathalters auf einem Gaslager liegt und das Einsatzstück (3) bzw. die elektrisch leitfähigere Zone dem Boden der Lagerausnehmung (9) zugeordnet ist.

8. Vorrichtung nach einem oder mehreren der vorhergehenden Ansprüche oder insbesondere danach, **dadurch gekennzeichnet, dass** die ein oder mehreren Einsatzstücke aus Molybdän, Tantal, Wolfram oder dergleichen bestehen.

9. Vorrichtung nach einem oder mehreren der vorhergehenden Ansprüche oder insbesondere danach, **dadurch gekennzeichnet, dass** der Substrathalter (2) von einer HF-Spule (5) umgeben ist.

10. Vorrichtung nach einem oder mehreren der vorhergehenden Ansprüche oder insbesondere danach, **dadurch gekennzeichnet, dass** der Substrathalter (2) oberhalb einer HF-Spule (5) angeordnet ist.

11. Vorrichtung nach einem oder mehreren der vorhergehenden Ansprüche oder insbesondere danach, **dadurch gekennzeichnet, dass** der Reaktor, dem der Substrathalter (2) zugeordnet ist, ein Kaltwandreaktor ist, dessen Wände ausschließlich von der Strahlung des beheizten Substrathalters (2) erwärmt werden.

12. Vorrichtung nach einem oder mehreren der vorhergehenden Ansprüche oder insbesondere danach, **dadurch gekennzeichnet, dass** der Reaktor ein Tunnelreaktor ist.

13. Vorrichtung nach einem oder mehreren der vorhergehenden Ansprüche oder insbesondere danach, **dadurch gekennzeichnet, dass** der Reaktor ein planetarer Reaktor mit zentralem Gaszufluss und sich drehendem Substrathalter (2) ist, welcher Lager einer Vielzahl zum Zentrum des Substrathalters (2) planetenartig angeordneter Substratlagerscheiben (4) ist, welche Substratlagerscheiben (4) jeweils auf einem Gaslager rotieren.

## Claims

1. Device for depositing in particular crystalline layers on an in particular crystalline substrate (1), having a high-frequency-heated substrate holder (2) made from conductive material for holding the substrate (1) with surface-to-surface contact, which substrate holder (2) has a zone (3) of higher electrical conductivity, **characterized in that** the zone of higher electrical conductivity is associated with the supported surface of the substrate (1).

2. Device according to Claim 1 or in particular according thereto, **characterized in that** the zone (3) of higher electrical conductivity substantially corresponds to the area taken up by the substrate (1).

3. Device according to one or more of the preceding claims or in particular according thereto, **characterized in that** the zone (3) is formed by an insert piece (3) made from metal in a substrate holder (2) which consists in particular of coated graphite.

4. Device according to one or more of the preceding claims, or in particular according thereto, **characterized in that** the substrate holder (2) has one or more substrate-bearing disks (4), which are in particular mounted on a gas bearing and each have an associated insert piece (3).

5. Device according to one or more of the preceding claims or in particular according thereto, **characterized in that** the insert piece (3) is directly associated with the substrate bearing disk (4) and in particular the entire substrate bearing disk (4) consists of metal.

6. Device according to one or more of the preceding claims or in particular according thereto, **characterized by** a multiplicity of substrate bearing disks (4) disposed in planetary fashion on a substrate holder.

7. Device according to one or more of the preceding claims or in particular according thereto, **characterized in that** the substrate bearing disk (4) is located on a gas bearing in a bearing recess (9) in the substrate holder and the insert piece (3) or the more electrically conductive zone is associated with the base of the bearing recess (9).

8. Device according to one or more of the preceding claims or in particular according thereto, **characterized in that** the one or more insert pieces consist of molybdenum, tantalum, tungsten or the like.

9. Device according to one or more of the preceding claims or in particular according thereto, **characterized in that** the substrate holder (2) is surrounded by an HF coil (5).

10. Device according to one or more of the preceding claims or in particular according thereto, **characterized in that** the substrate holder (2) is disposed above an HF coil (5).

11. Device according to one or more of the preceding claims or in particular according thereto, **characterized in that** the reactor, with which the substrate holder (2) is associated, is a cold-wall reactor, the walls of which are heated only by the radiation of the heated substrate holder (2).

12. Device according to one or more of the preceding claims or in particular according thereto, **characterized in that** the reactor is a tunnel reactor.

13. Device according to one or more of the preceding claims or in particular according thereto, **characterized in that** the reactor is a planetary reactor with a central gas feed and a rotating substrate holder (2), which is support for a multiplicity of substrate bearing disks (4) arranged in planetary fashion with respect to the center of the substrate holder (2), which substrate bearing disks (4) in each case rotate on a gas bearing.

## Revendications

1. Dispositif de dépôt de couches, notamment cristallines, sur un substrat (1), notamment cristallin, ledit dispositif comportant un porte-substrat (2), chauffé à haute fréquence et fabriqué à partir d'un matériau conducteur, ledit porte-substrat (2) supportant sur sa surface le substrat (1) et comportant une zone (3) de conductibilité électrique plus élevée, **caractérisé en ce que** la zone de conductibilité électrique plus élevée est associée à la surface de support du substrat (1).

2. Dispositif selon la revendication 1, **caractérisée en ce que** la zone (3) de conductibilité électrique plus élevée correspond sensiblement à la surface occupée par le substrat (1).

3. Dispositif selon l'une ou plusieurs des revendications précédentes, ou notamment selon celles-ci, **caractérisé en ce que** la zone (3) est formée par une pièce d'insertion (3) en métal, dans un porte-substrat (2) en graphite comportant notamment un revêtement.

4. Dispositif selon l'une ou plusieurs des revendications précédentes, ou notamment selon celles-ci, **caractérisé en ce que** le porte-substrat (2) comporte un ou plusieurs disques de support de substrat (4), notamment à rotation sur support gazeux, à chacun desquels étant associé une pièce d'insertion (3).

5. Dispositif selon l'une ou plusieurs des revendications précédentes, ou notamment selon celles-ci, **caractérisé en ce que** la pièce d'insertion (3) est associée directement au disque de support de substrat (4) et notamment tout le disque de support de substrat (4) est en métal.

6. Dispositif selon l'une ou plusieurs des revendications précédentes, ou notamment selon celles-ci, **caractérisé par** un grand nombre de disques de support de substrat (4) qui sont disposés sur un porte-substrat à la manière d'un système planétaire.

7. Dispositif selon l'une ou plusieurs des revendications précédentes, ou notamment selon celles-ci, **caractérisé en ce que** le disque de support de substrat (4) est placé dans un évidement de support (9) du porte-substrat sur un support gazeux et la pièce d'insertion (3), ou le cas échéant la zone électriquement plus conductrice, est associée au fond de l'évidement de support (9).

8. Dispositif selon l'une ou plusieurs des revendications précédentes, ou notamment selon celles-ci, **caractérisé en ce qu'**une ou plusieurs pièces d'insertion sont en molybdène, tantale, tungstène ou analogue.

9. Dispositif selon l'une ou plusieurs des revendications précédentes, ou notamment selon celles-ci, **caractérisé en ce que** le porte-substrat (2) est entouré d'une bobine HF (5).

10. Dispositif selon l'une ou plusieurs des revendications précédentes, ou notamment selon celles-ci, **caractérisé en ce que** le porte-substrat (2) est disposé au-dessus d'une bobine HF (5).

11. Dispositif selon l'une ou plusieurs des revendications précédentes, ou notamment selon celles-ci, **caractérisé en ce que** le réacteur, auquel est associé le porte-substrat (2), est un réacteur à parois froides dont les parois sont chauffées exclusivement par le rayonnement émis par le porte-substrat chauffé (2).

12. Dispositif selon l'une ou plusieurs des revendications précédentes, ou notamment selon celles-ci, **caractérisé en ce que** le réacteur est un réacteur à tunnel.

13. Dispositif selon l'une ou plusieurs des revendications précédentes, ou notamment selon celles-ci, **caractérisé en ce que** le réacteur est un réacteur planétaire comportant une amenée de gaz centrale et un porte-substrat rotatif (2), qui supporte un grand nombre de disques de support de substrat (4) disposés à la manière d'un système planétaire autour du centre du porte-substrat (2), lesquels disques de support de substrat (4) sont chacun en rotation sur un support gazeux.
